# EUROPEAN PATENT SPECIFICATION

(11) **EP 2 191 329 B1**
(45) Date of publication and mention of the grant of the patent: **15.06.2016**
(21) Application number: 08799282.2
(22) Date of filing: 07.09.2008
(51) Int. Cl.: G03F 7/20

(54) **SYSTEM AND METHOD FOR EXPOSING A DIGITAL POLYMER PLATE**
SYSTEM UND VERFAHREN ZUM BELICHTEN EINER DIGITALEN POLYMERPLATTE
SYSTÈME ET PROCÉDÉ POUR EXPOSER UNE PLAQUE DE POLYMÈRE NUMÉRIQUE

(30) Priority: 07.09.2007 US 970682 P
(43) Date of publication of application: 02.06.2010
(73) Proprietor: Precision Rubber Plate Co., Inc., Indianapolis, IN 46203 (US)
(72) Inventor: WIER, Edwin, N., Martinsville, IN 46151 (US); GREEN, Chris, Whiteland, IN 46184 (US)
(74) Representative: Wood, Graham
(86) International application number: PCT/US2008/075531
(87) International publication number: WO 2009/033124

(56) References cited:
- WO-A1-2006/042676
- WO-A2-01/39897
- US-A- 3 723 120
- US-A- 5 888 701
- US-A1- 2003 129 533
- US-A1- 2004 259 033
- US-A1- 2005 231 708
- US-A1- 2005 266 358
- US-A1- 2006 055 761
- US-A1- 2006 124 008
- US-B2- 6 773 859

## Description

### RELATED APPLICATION DATA

This application claims the benefit of US Provisional App. No. 60/970,682 filed September 7, 2007.

### TECHNICAL FIELD

The present invention is generally related to the production of flexographic printing plates according to a digital workflow. More particularly, but not exclusively, it is related to systems and techniques for exposing a digital polymer plate in a reduced oxygen environment to increase the sharpness and clarity of the printed image. In a preferred form, the invention provides techniques for digitally producing flexographic printing plates that are of suitable sharpness and clarity that they may be used commercially to print directly on corrugated materials.

### DESCRIPTION

Flexography is a method of printing that is commonly used for high-volume runs. Conventional (i.e. non-digital) flexography is employed for printing on a variety of substrates such as paper, paperboard stock, corrugated board, films, foils and laminates. Newspapers and grocery bags are prominent examples. Coarse surfaces and stretch films can be economically printed only by means of flexography.

Flexographic printing plates are relief plates with image elements raised above open areas. Generally, the plate is somewhat soft, and flexible enough to wrap around a printing cylinder, and durable enough to print over a million copies. Such plates offer a number of advantages to the printer, based chiefly on their durability and the ease with which they can be made.

### Conventional (non-digital) flexography

A conventional (non-digital) flexographic printing plate as delivered by its manufacturer is generally a multilayered article made of, in order, a backing, or support layer; one or more unexposed photocurable layers; a protective layer or slip film; and a cover sheet.

The backing layer lends support to the plate, and is typically a plastic film or sheet, which may be transparent or opaque.

The photocurable layer(s) can include any of the known photopolymers, monomers, initiators, reactive or non-reactive diluents, fillers, and dyes. The term "photocurable" refers to a solid composition which undergoes polymerization, cross-linking, or any other curing or hardening reaction in response to actinic radiation with the result that the unexposed portions of the material can be selectively separated and removed from the exposed (cured) portions to form a three-dimensional or relief pattern of cured material. Preferred photocurable materials include an elastomeric compound, an ethylenically unsaturated compound having at least one terminal ethylene group, and a photoinitiator. Exemplary photocurable materials are disclosed in European Patent Application Nos. 0 456 336 A2 and 0 640 878 A1 to Goss, et al., British Patent No. 1,366,769, U.S. Pat. No. 5,223,375 to Berrier, et al., U.S. Pat. No. 3,867,153 to Macl.ahan, U.S. Pat. No. 4,264,705 to Allen, U.S. Pat. Nos. 4,323,636, 4,323,637, 4,369,246, and 4,423,135 all to Chen, et al., U.S. Pat. No. 3,265,765 to Holden, et al., U.S. Pat. No. 4,320,188 to Heinz, et al., U.S. Pat. No. 4,427,759 to Gruetzmacher, et al., U.S. Pat. No. 4,622,088 to Min, and U.S. Pat. No. 5,135,827 to Bohm, et al.

If a second photocurable layer is used, i.e., an overcoat layer, it typically is disposed upon the first layer and is similar in composition.

The photocurable materials generally cross-link (cure) and harden in at least some actinic wavelength region. As used herein, actinic radiation is radiation capable of effecting a chemical change in an exposed moiety. Actinic radiation includes, for example, amplified (e.g., laser) and non-amplified light, particularly in the UV and infrared wavelength regions. Preferred actinic wavelength regions are from about 250 nm to about 450 nm, more preferably from about 300 nm to about 400 nm, even more preferably from about 320 nm to about 380 nm. One suitable source of actinic radiation is a UV lamp, although other sources are generally known to those skilled in the art.

The slip film used during conventional flexography is a thin sheet which protects the photopolymer from dust and increases its ease of handling. Instead of a slip film, a matte layer has been used to improve the ease of plate handling. The matte layer typically comprises fine particles (silica or similar) suspended in an aqueous binder solution. The matter layer is coated onto the photopolymer layer and then allowed to air dry.

In a conventional, film-based (i.e. non-digital) plate making process, the image to be printed is stored in a film negative. The slip film (or matte layer) which covers the unexposed polymer layer is transparent to UV light. The printer peels the cover sheet off the printing plate blank and places the film negative on top of the slip film. The plate is then subjected to flood-exposure of UV light through the film negative. This results in imagewise exposure of the photopolymer layer according to the image contained in the film negative. The areas of the printing plate blank that are exposed to the UV light cure, or harden. The unexposed areas are then removed (developed) to create the relief image of the negative on the printing plate.

### Digital flexography

A "digital" or "direct to plate" plate making processes eliminates the need to provide the image to be printed in the form of a film negative. Instead, the image is stored as an electronic data file (e.g. on a computer) which can be easily stored and/or altered for different purposes.

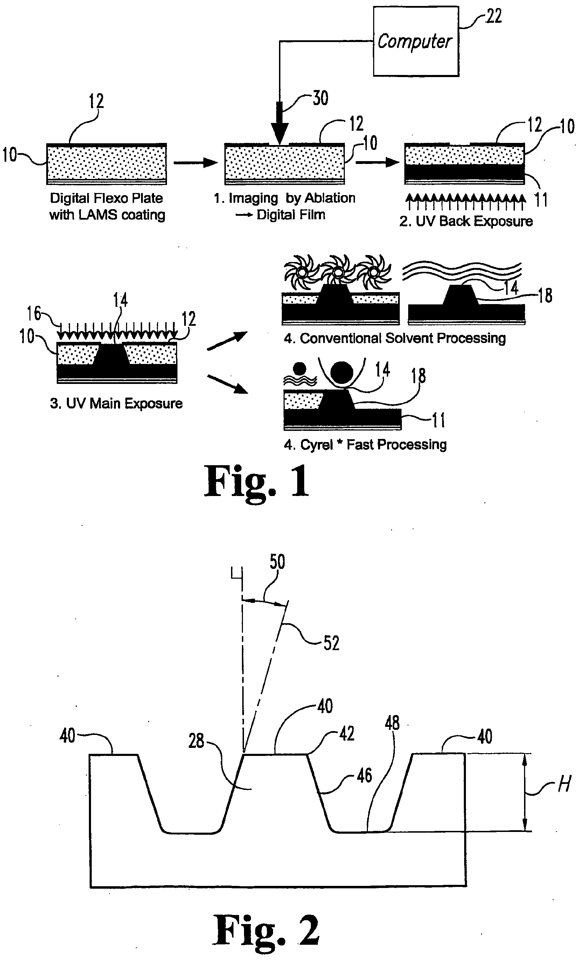

Referring to FIG. 1, a typically process for producing a digital flexographicplate is schematically depicted. A digital printing plate blank 10 is provided with a "digital" (i.e. photo ablatable) masking layer 12. This masking layer is generally a modified slip film, for example, a slip film layer which has been doped with a UV• absorbing material, such as carbon black, and it is typically designed so as to be ablated by commercially available laser equipment. The laser ablatable masking layer (LAMS) is typically provided by the manufacturer of the printing blank and can be any photoablative masking layer known in the art. Examples of laser ablatable layers suitable for use in digital polymer plates are disclosed for example, in U.S. Pat. No. 5,925,500 to Yang, et al., and U.S. Pat. Nos. 5,262,275 and 6,238,837 to Fan. The laser ablatable layer generally comprises a radiation absorbing compound and a polymeric binder. The radiation absorbing compound is chosen to be sensitive to the wavelength of the laser and is generally selected from dark inorganic pigments, carbon black, and graphite.

The polymeric binder is generally selected from polyacetals, polyacrylics, polyamides, polyimides, polybutylenes, polycarbonates, polyesters, polyethylenes, cellulosic polymers, polyphenylene ethers, polyethylene oxides, and combinations of the foregoing, although other suitable binders would also be known to those skilled in the art. The binder is selected to be compatible with the underlying photopolymer and easily removed during the development (wash) step. Preferred binders include polyamides, and cellulosic binders, such as hydroxypropyl cellulose.

During the digital imaging process, indicated as step one in FIG 1, a laser 30 is guided by the image stored in the electronic data file on computer 22 to ablate selected portions of the masking layer 12. The masking layer that remains in place (i.e. the unablated portions of the mask) becomes a negative of the image that is created in situ on the digital plate blank. This negative created in situ is often called a "digital film."

The back side of the blank 10 is then typically subject to UV exposure to produce a hardened backing layer 11. The hardened backing layer 11 facilitates subsequent handling of the plate during processing and/or printing. Alternatively or in addition, the plate 10 is mounted to a support plate or platen or this step is omitted.

After the ablation, or "digital imaging", of the masking layer, the photosensitive printing element is subject to flood exposure ofUV light 16 through the digital film 12, as indicated in step 3. The UV exposure cures the exposed portions 14 of the underlying photopolymer layer. The cured blank is then developed to remove the masking layer and the unpolymerized portions of the photocurable material to create a relief image on the surface of the photosensitive printing element as illustrated in step 4. Typical methods of development include washing with various solvents or water, often with a brush. Other possibilities for development include the use of an air knife or heat plus a blotter, such as employed with the commercially available Dupont Cyrel Fast system.

The resulting surface has a series of pedestals 18 that reproduces the image to be printed. The printing element may then be mounted on a press and printing commences. During printing, ink is transferred to the top surface (e.g. at 14) of pedestals 18 and then onto the printed surface.

Flexographic printing plates produced by current digital or direct to plate techniques work well in printing on smooth, hard surfaces, such as preprint liner. However, the usefulness of current digital processing techniques has been limited in applications where the printing surface is softer and/or irregular, such as in printing directly on corrugated materials (e.g. cardboard boxes) in what is referred to as "post print." A common problem often encountered with printing on corrugated board substrates is the occurrence of a printing effect that is typically referred to as fluting or banding.

The sharpness and clarity of a printing plate can be influenced by the shape and characteristics of the pedestals or "dots." Referring to FIG. 2, a pedestal 28 has a top ink receptive surface 40 and a downwardly sloping side surface 46 surrounding the pedestal and providing a generally truncated conical configuration for the pedestal. Side surface 46 begins at the top edge 42 and terminates in a trough 48 extending between the adjacent pedestals. The pedestal height H is the vertical distance between the top surface 40 and the bottom of trough 48. The pedestal angle 50 is a reflection of the slope of the upper portion of side surface 46. If there is any curvature of the side surface 46, the pedestal angle 50 may be taken based on the line 52 connecting edge 42 and a point midway down the side surface 46.

Sharpness and clarity are typically increased when the edges 42 are sharp and the pedestal angle 50 is small (i.e. line 51 is relatively closer to vertical). The reason for this is that pedestal 28 may be compressed when contacted by an ink roller. When the edges 42 are not sharp (i.e. become rounded shoulders) and/or the angle 50 is large, ink can be transferred onto the side surface 46. When the photopolymer plate is used to transfer the image onto an external surface, the pedestals may again be compressed thereby, transferring the ink not only from surface 40 but also side surface 46 onto the external surface. When this occurs, it can cause a ring around the image formed on the final copy. Accordingly, it is desirable to produce pedestals with sharp edges 42 and a relatively steep angle 50.

The UV main exposure in conventional digital processing (step 3 in FIG. 1) typically occurs in air. Accordingly, the exposed portions 14 of the photopolymer 10 are not only exposed to light but also the constituents of air. Applicants have found that by conducting the UV main exposure in a reduced-oxygen environment, significantly greater sharpness and clarity can be achieved. Without intending to be bound by any theory of operation, it is believed that the presence of atmospheric oxygen during photopolymerization adversely affects the bonding of the polymer molecules. By reducing the exposure to atmospheric oxygen, Applicants have demonstrated that a sharper angle and crisper edges can be produced.

The solution of the present invention is defined in independent claims 1 and 2. This disclosure includes several embodiments some of which are embodiments of the invention.

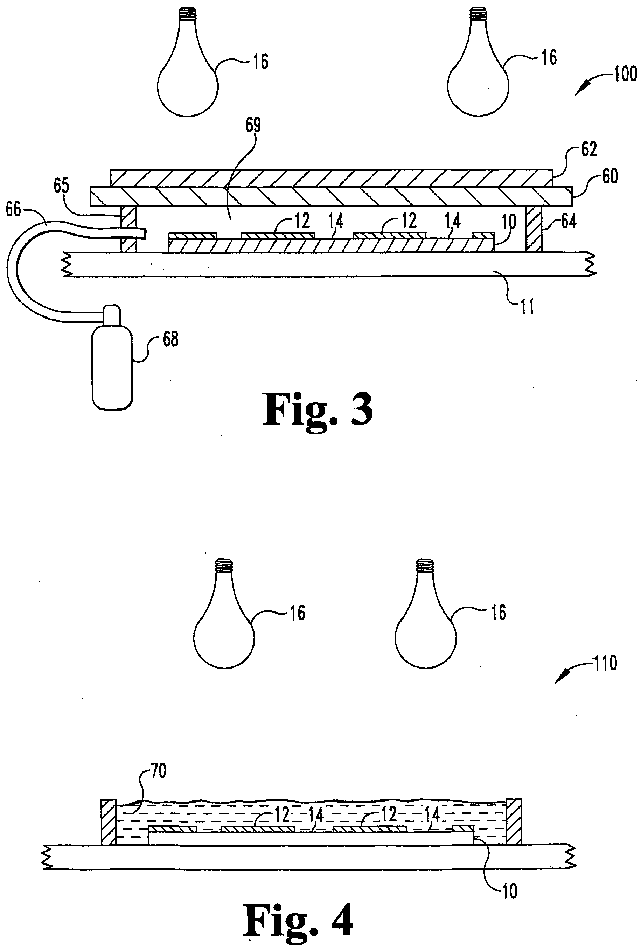

Referring now to FIG. 3, a UV exposure station 100 according to one aspect of the present invention is schematically depicted. As described above, after digital imaging, the photopolymer 10 includes an ablated masking layer 12 with exposed regions 14. The photopolymer is supported by its backing layer 11 (and/or mounted on a platen) and placed into chamber 69. Chamber 69 is constructed to contain an atmosphere with reduced oxygen content. In the illustrated embodiment of the invention, chamber 69 is defined by side walls 64 and 65 and has a removable top 60 made of a UV transparent material, such as glass. With top 60 removed, carbon dioxide is provided from tank 68 into chamber via supply line 66. Because carbon dioxide is heavier than oxygen, it displaces the oxygen surrounding photopolymer 10, which is allowed to escape from the top of chamber 69. Once chamber 69 has been adequately filled with carbon dioxide, top 60 is placed over walls 64, 65 to seal chamber 69. UV lights 16 are then turned on to activate the photopolymerization and cure the exposed regions 14 of photopolymer 10. Once the photopolymerization is complete, the photopolymer plate is removed from chamber 69 and subjected to any conventional developing steps to remove the uncured photopolymer.

As illustrated, station 100 also includes an optional UV filter 62, which may be placed over glass top 60. UV filter 62 may be a linear polarizer or a coliminating filter which, as described more fully in US. Patent No. 6,766,740, may be used to limit the amount of UV light from bulbs 16 that is incident on photopolymer 10 at other than a right angle. Filter 62 may alternatively be located below glass top 60 or filter 62 may be omitted.
It is to be appreciated that station 100 is adapted to subject exposed regions 14 of photopolymer 10 to a relatively inert atmosphere during the UV exposure.
This relatively inert atmosphere can be composed of a variety of gases that do not interfere with the photopolymerization process, such as argon and carbon dioxide. Other known inert gasses and mixtures of inert gasses can be employed as would occur to those of skill in the art. It is expected that a suitable atmosphere will have an oxygen concentration that is substantially less than the concentration of oxygen in the surrounding air (i.e. less than 21 % oxygen). Preferably, chamber 69 is configured to have a concentration of oxygen that is 50% less than the concentration of oxygen in the surrounding air (i.e, less than about 10.5% oxygen), more preferably 75% less (i.e. less than about 5.3% oxygen), and most preferably 90% less (i.e. less than about 2.1% oxygen).

The inert atmosphere can be inserted into chamber 69 by a variety of mechanisms. According to one embodiment of the invention, chamber 69 can be configured with check valves to release oxygen as it is displaced with the location of the check valves dependent on the relative weight of the displacing gas. Alternatively or in addition, a vacuum may be applied to chamber 69 prior to or during introduction of gas from tank 68.

Referring now to FIG. 4, an alternative mechanism for reducing the exposure of the open areas 14 to atmospheric oxygen during UV exposure is depicted. Whereas station 100 is configured to provide a relatively inert gas, station 110 is configured to provide a liquid 70 around plate 10 during the UV exposure. Otherwise, the function of station 110 is identical to station 100, including the provision of an optional UV filter (not shown).

Liquid 70 is selected such that it transmits UV light and has a low dissolved oxygen concentration. In one form, liquid 70 includes at least one oxygen scavenger which binds with oxygen to reduce the concentration of oxygen in the liquid 70. In one form, liquid 70 is a solution of water and an oxygen scavenger.

One convenient solution that has been found suitable is a Post-X solution, which is a material typically used to clean the plate after etching. For example, it has been found that 0.5 lbs of X3000 Finishing solution (MacDermid Inc., Waterbury CT) can be added to 5 gallons of water to create a useful liquid 70 for use in station 110. X3000 is a solid powder having a pH of 9.0 at a 1 % solution.

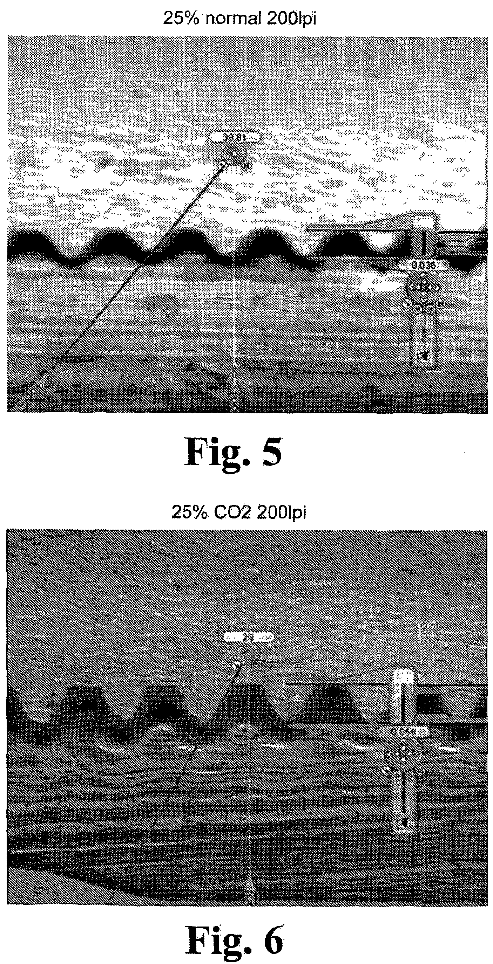

The UV exposure techniques described herein can be used to produce pedestals with significantly improved characteristics. For example, FIGS. 5 and 6 are enlarged side pictures comparing pedestals made with the UV exposure occurring in air (FIG. 5) versus in a CO₂ rich environment (FIG. 6). The CO₂ rich environment was created by filling an open chamber with CO₂ and then covering the chamber with a glass top. Under otherwise identical processing conditions, the pedestal made with the UV exposure in a CO₂ rich environment had a steeper pedestal angle (approximately 29° versus approximately 39°). The CO₂ rich environment also produced a pedestal height approximately 60 % greater (.058/.036). Similar results were observed for pedestals created in an approximately 1% Post X solution. More generally, it is expected that the present invention can be used to produce dots having a pedestal angle less than 35° from vertical, for example less than 34, 33, 32, 31 or 30° from vertical.

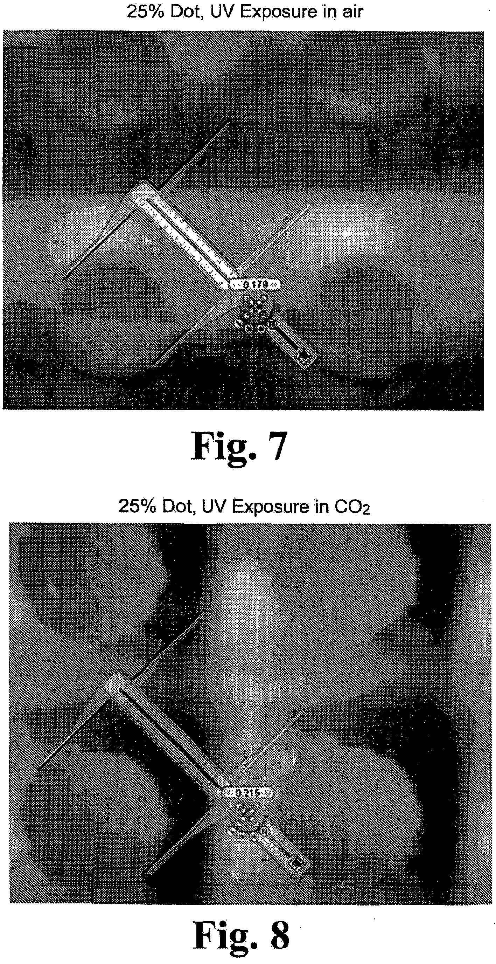

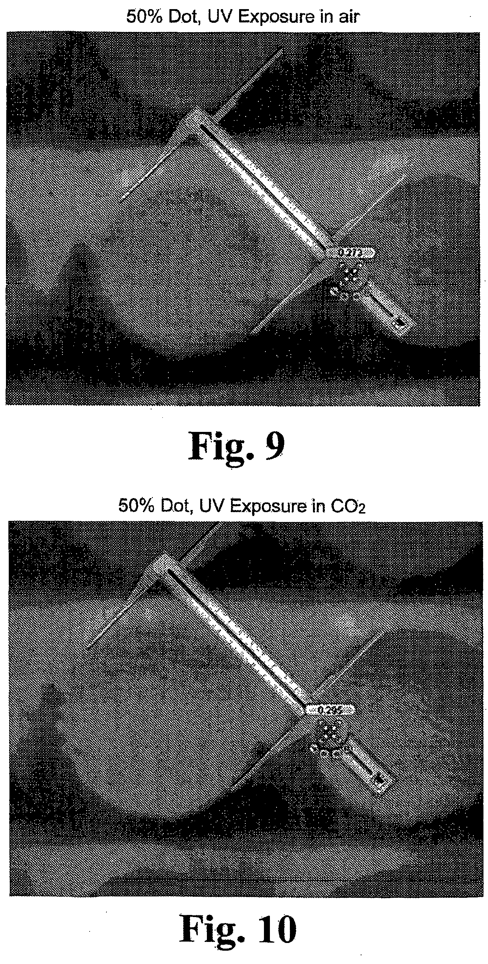

Another benefit that may be realized with the CO₂ rich environment is closer correspondence with the digital image. In other words, the size of the flat top surface 40 of the pedestal more closely corresponds to the size of the corresponding opening in the mask, which opening is created by the laser ablation. For example, FIGS. 7 and 8 show enlarged face shots of 25% dots created from UV exposure in air (FIG. 7) and the CO₂ rich environment (FIG. 8) as described above. FIGS. 9 and 10 provide a similar comparison for 50% dots. Even though the digital mask was the same for each dot size, the top surfaces 40 of the pedestals formed with the CO₂ rich atmosphere (FIGS. 8 and 10) are much larger in diameter than the flat top surfaces 40 of the dots formed by UV exposure in air (FIGS. 7 and 9). This larger diameter (.215 versus .179 for 25% dots, .295 versus .273 for 50% dots) indicates a much closer correspondence to the corresponding opening of the digital mask. Similar results were observed for pedestals created in an approximately 1% Post X solution.

The reduction in diameter of the flat top surface 40 during conventional digital processing is related to the rounding of the top edge 42. This rounding is evident by comparing the profiles of the conventionally produced 25% digital dot (FIG. 5) with the 25% digital dot formed by UV exposure in a CO2 environment (FIG. 6). The rounded edges are also evident by comparing the face shots of the conventionally produced 25% and 50% dots (FIGS. 7 and 9) with the 25% and 50% dots formed by UV exposure in a CO2 environment (FIGS. 8 and 10). For example, the dots formed by UV exposure in a CO2 environment (FIGS. 8 and 10) retain the uneven edge detail of the masking layer (which detail is attributable to the process of laser ablation) whereas no such edge detail is evident in the conventionally produced dots (FIGS. 7 and 9).

In preferred implementations, the processes of the present invention may be used to produce plates suitable for printing directly on corrugated paper. In these or other implementations, the processes may be used to create pedestals having a pedestal angle less than 35°, for example less than 30°. In these or other implementations, the processes may be used to create 25% dots having a diameter within about 90% of the diameter of the corresponding opening the digital mask, more preferably within 95%, more preferably within 97%. In these or other implementations, the processes may be used produce 50% dots having a diameter within about 95% of the diameter of the corresponding opening in the digital mask, more preferably within 97% or 99%.

It is to be appreciated that what has been described is a method of transferring a digital image onto a printing plate comprising: providing a photopolymer printing plate having a photopolymer layer and an ablatable mask layer; ablating the mask layer to create an ablated mask layer corresponding to the image; subjecting exposed portions of the photopolymer layer to an oxygen reduced fluid environment; and during the subjecting, shining light on the ablated mask layer to polymerize the exposed portions of the photopolymer layer. The oxygen reduced fluid environment may be a liquid environment, such as a basic solution comprising an oxygen scavenger. The oxygen reduced fluid environment may be a gaseous environment, such as one that is rich in CO2. The photopolymer can be developed in any conventional fashion and then used to print the image, for example, directly on corrugated material.

What has also been described is an improvement to the process of producing a flexographic printing plate wherein a digital data file is transposed into an in-situ mask layer adjacent a photopoymerizable layer and the photopoymerizable layer is exposed to actinic radiation through the mask layer and subsequently developed to form a relief printing form having a pattern of printing areas, the improvement comprising subjecting the mask layer to an inert gas environment having a concentration of oxygen less than about 10% while performing the exposure to actinic radiation through the mask layer. The inert gas environment may be rich in CO₂ and/or comprise a mixture of other inert gasses. A polarizer may be positioned between the source of actinic radiation and the mask layer during the exposure. The relief printing form that is produced may be used to print on corrugated material. The pattern of printing areas that results may be composed of a series of flat topped dots, for example wherein a 25% dot has a flat top area with a diameter that is within 95% of the corresponding diameter in the in-situ mask.

What has also been described is an improvement to the process of producing a flexographic printing plate wherein a digital data file is transposed into an in-situ mask layer adjacent a photopoymerizable layer and the photopoymerizable layer is exposed to actinic radiation through the mask layer and subsequently developed to form a relief printing form having a pattern of printing areas comprising a series of dots, the improvement comprising: during the exposure to actinic radiation through the mask layer, subjecting the mask layer to a reduced oxygen environment such that the resulting dots have flat top surfaces that correspond in size to the size of the corresponding openings in the in situ mask, wherein a 25% dot has a flat top surface with a diameter that is within 95% of the corresponding diameter in the in-situ mask. The process may be implemented such that a 50% dot has a flat top surface with a diameter that is within 97% of the corresponding diameter in the in-situ mask.

What has also been described is a method for producing a flexographic printing plate comprising flat topped dots having crisp edges and steep bevel angles that is suitable for printing directly on currogated materials, comprising providing a photopolymer printing plate having a photopolymer layer and an ablatable mask layer; ablating the mask layer to create an ablated mask layer corresponding to a digital image file; subjecting exposed portions of the photopolymer layer to an inert atmosphere having a concentration of oxygen less than 10%; and during the subjecting, shining light on the ablated mask layer to polymerize the exposed portions of the photopolymer layer. The process may be implemented to produce a 25% dot has a flat top surface with a diameter that is within 95% of the corresponding diameter in the mask. The process may also be implemented such that a 25% dot has a flat top surface with a diameter that is within 97% of the corresponding diameter in the mask.

## Claims

1. A method of transferring a digital image onto a photopolymer printing plate by creating a relief printing form, said method comprising the steps of:
providing a photocurable printing plate blank including an uncured photocurable layer (10) and an ablatable mask layer;
laser ablating the mask layer to form openings in the same and creating an ablated mask layer (12) corresponding to the image;
placing the photocurable printing plate blank in a chamber (69) defined by side walls (64, 65) and a removable top (60) made of a UV transparent material;
subjecting exposed portions of the uncured photocurable layer to a reduced oxygen environment by the introduction from a tank (68) of an inert gas heavier than oxygen to the air surrounding the printing plate blank inside the chamber with the top removed to allow the displaced oxygen to escape;
placing the top over the walls to seal the chamber;
exposing the photocurable printing plate blank including the ablated mask layer and the exposed portions of the photocurable layer to a flood of actinic radiation, the actinic radiation passing through the openings (14) in the ablated mask layer to cure the exposed portions of the photocurable layer; and
removing the ablated mask layer and uncured portions of the photocurable layer to create a relief image formed by a series of pedestals (28) that reproduce the image.

2. A method of transferring a digital image onto a photopolymer printing plate by creating a relief printing form, said method comprising the steps of:
providing a photocurable printing plate blank including an uncured photocurable layer (10) and an ablatable mask layer;
laser ablating the mask layer to form openings in the same and creating an ablated mask layer (12) corresponding to the image;
placing the photocurable printing plate blank in a chamber (69) defined by side walls (64, 65) and a removable top (60) made of a UV transparent material;
subjecting exposed portions of the uncured photocurable layer to a reduced oxygen environment by the introduction of an inert gas from a tank (68) to displace oxygen in the chamber;
said chamber configured with check valves with the location of said check valves dependent on the relative weight of the displacing inert gas;
exposing the photocurable printing plate blank including the ablated mask layer and the exposed portions of the photocurable layer to a flood of actinic radiation, the actinic radiation passing through the openings (14) in the ablated mask layer to cure the exposed portions of the photocurable layer; and
removing the ablated mask layer and uncured portions of the photocurable layer to create a relief image formed by a series of pedestals (28) that reproduce the image.

3. A method according to claim 2 wherein a vacuum is applied to the chamber prior to or during introduction of inert gas from the tank (68).

4. The method of claim 1 or 2 wherein the reduced oxygen environment contains oxygen in an amount less than 10.5% by volume

5. The method of claim 1 or 2 wherein said environment includes supplied inert gas carbon dioxide and/or argon.

6. The method of any of the preceding claims wherein the actinic radiation includes light that is shined through a polarizer.

7. A method of printing on a corrugated material using a relief printing form formed in accordance with the method of claims 1-6.

8. The method of claims 1-6 in which the environment contains oxygen in an amount less than 5.3% by volume.

9. The method of claims 1-6 in which the environment contains oxygen in an amount less than 2.1 % by volume.

## Patentansprüche

1. Verfahren zum Übertragen eines digitalen Bilds auf eine Fotopolymerdruckplatte durch Erzeugen einer Reliefdruckform, wobei das genannte Verfahren die folgenden Schritte aufweist:
Bereitstellen eines lichtaushärtenden Druckplattenrohlings, der eine ungehärtete lichtaushärtende Schicht (10) und eine ablatierbare Maskenschicht beinhaltet;
Laserablatieren der Maskenschicht, um Öffnungen in derselben zu bilden, und Erzeugen einer ablatierten Maskenschicht (12), die dem Bild entspricht;
Legen des lichtaushärtenden Druckplattenrohlings in eine Kammer (69), die von Seitenwänden (64, 65) und einem aus einem UV-durchlässigen Material hergestellten abnehmbaren Oberteil (60) definiert wird;
Inkontaktbringen von freiliegenden Teilen der ungehärteten lichtaushärtenden Schicht mit einer sauerstoffreduzierten Umgebung durch die Einführung eines Inertgases, das schwerer als Sauerstoff ist, aus einem Behälter (68) in die den Druckplattenrohling umgebende Luft im Inneren der Kammer bei abgenommenem Oberteil, um den verdrängten Sauerstoff entweichen zu lassen;
Aufsetzen des Oberteils auf die Wände zum dichten Verschließen der Kammer;
Flutbelichten des lichtaushärtenden Druckplattenrohlings einschließlich der ablatierten Maskenschicht und der freiliegenden Teile der lichtaushärtenden Schicht mit aktinischer Strahlung, wobei die aktinische Strahlung durch die Öffnungen (14) in der ablatierten Maskenschicht dringt, um die freiliegenden Teile der lichtaushärtenden Schicht auszuhärten; und
Entfernen der ablatierten Maskenschicht und ungehärteten Teile der lichtaushärtenden Schicht zum Erzeugen eines Reliefbilds, das von einer Reihe von Erhebungen (28) gebildet wird, die das Bild reproduzieren.

2. Verfahren zum Übertragen eines digitalen Bilds auf eine Fotopolymerdruckplatte durch Erzeugen einer Reliefdruckform, wobei das genannte Verfahren die folgenden Schritte aufweist:
Bereitstellen eines lichtaushärtenden Druckplattenrohlings, der eine ungehärtete lichtaushärtende Schicht (10) und eine ablatierbare Maskenschicht beinhaltet;
Laserablatieren der Maskenschicht, um Öffnungen in derselben zu bilden, und Erzeugen einer ablatierten Maskenschicht (12), die dem Bild entspricht;
Legen des lichtaushärtenden Druckplattenrohlings in eine Kammer (69), die von Seitenwänden (64, 65) und einem aus einem UV-durchlässigen Material hergestellten abnehmbaren Oberteil (60) definiert wird;
Inkontaktbringen von freiliegenden Teilen der ungehärteten lichtaushärtenden Schicht mit einer sauerstoffreduzierten Umgebung durch die Einführung eines Inertgases aus einem Behälter (68) zum Verdrängen von Sauerstoff in der Kammer;
wobei die genannte Kammer mit Rückschlagventilen ausgestaltet ist, wobei die Lage der genannten Rückschlagventile vom relativen Gewicht des verdrängenden Inertgases abhängt;
Flutbelichten des lichtaushärtenden Druckplattenrohlings einschließlich der ablatierten Maskenschicht und der freiliegenden Teile der lichtaushärtenden Schicht mit aktinischer Strahlung, wobei die aktinische Strahlung durch die Öffnungen (14) in der ablatierten Maskenschicht dringt, um die freiliegenden Teile der lichtaushärtenden Schicht auszuhärten; und
Entfernen der ablatierten Maskenschicht und ungehärteten Teile der lichtaushärtenden Schicht zum Erzeugen eines Reliefbilds, das von einer Reihe von Erhebungen (28) gebildet wird, die das Bild reproduzieren.

3. Verfahren nach Anspruch 2, wobei vor oder während der Einführung von Inertgas aus dem Behälter (68) ein Vakuum an die Kammer angelegt wird.

4. Verfahren nach Anspruch 1 oder 2, wobei die sauerstoffreduzierte Umgebung Sauerstoff in einer Menge von weniger als 10,5 Volumen-% enthält.

5. Verfahren nach Anspruch 1 oder 2, wobei die genannte Umgebung das zugeführte Inertgas Kohlendioxid und/oder Argon beinhaltet.

6. Verfahren nach einem der vorhergehenden Ansprüche, wobei die aktinische Strahlung durch einen Polarisator gestrahltes Licht beinhaltet.

7. Verfahren zum Bedrucken eines gewellten Materials unter Verwendung einer Reliefdruckform, die gemäß dem Verfahren nach einem der Ansprüche 1 bis 6 ausgebildet wird.

8. Verfahren nach einem der Ansprüche 1 bis 6, bei dem die Umgebung Sauerstoff in einer Menge von weniger als 5,3 Volumen-% enthält.

9. Verfahren nach einem der Ansprüche 1 bis 6, bei dem die Umgebung Sauerstoff in einer Menge von weniger als 2,1 Volumen-% enthält.

## Revendications

1. Procédé de transfert d'une image numérique sur une plaque d'impression photopolymère grâce à la création d'une forme d'impression en relief, ledit procédé comprenant les étapes consistant à :
mettre à disposition une ébauche de plaque d'impression photodurcissable incluant une couche photodurcissable non durcie (10) et une couche de masque détachable par ablation;
détacher par ablation laser la couche de masque afin de former des ouvertures dans celle-ci et créer une couche de masque détachée par ablation (12) correspondant à l'image ;
placer l'ébauche de plaque d'impression photodurcissable dans une chambre (69) définie par des parois latérales (64, 65) et une partie supérieure amovible (60) réalisée en une matière transparente aux UV ;
soumettre des portions exposées de la couche photodurcissable non durcie à un environnement à oxygène réduit grâce à l'introduction, à partir d'un réservoir (68), d'un gaz inerte plus lourd que l'oxygène dans l'air qui entoure l'ébauche de plaque d'impression à l'intérieur de la chambre, la partie supérieure étant enlevée pour permettre à l'oxygène déplacé de s'échapper ;
placer la partie supérieure au-dessus des parois pour rendre la chambre étanche ;
exposer l'ébauche de plaque d'impression photodurcissable incluant la couche de masque détachée par ablation et les portions exposées de la couche photodurcissable à un flot de rayonnement actinique, le rayonnement actinique passant à travers les ouvertures (14) ménagées dans la couche de masque détachée par ablation afin de durcir les portions exposées de la couche photodurcissable ; et
enlever la couche de masque détachée par ablation et les portions non durcies de la couche photodurcissable afin de créer une image en relief formée par une série de colonnes (28) qui reproduisent l'image.

2. Procédé de transfert d'une image numérique sur une plaque d'impression photopolymère grâce à la création d'une forme d'impression en relief, ledit procédé comprenant les étapes consistant à :
mettre à disposition une ébauche de plaque d'impression photodurcissable incluant une couche photodurcissable non durcie (10) et une couche de masque détachable par ablation ;
détacher par ablation laser la couche de masque afin de former des ouvertures dans celle-ci et créer une couche de masque détachée par ablation (12) correspondant à l'image ;
placer l'ébauche de plaque d'impression photodurcissable dans une chambre (69) définie par des parois latérales (64, 65) et une partie supérieure amovible (60) réalisée en une matière transparente aux UV ;
soumettre des portions exposées de la couche photodurcissable non durcie à un environnement à oxygène réduit grâce à l'introduction d'un gaz inerte à partir d'un réservoir (68) afin de déplacer l'oxygène dans la chambre ;
ladite chambre étant configurée avec des soupapes d'arrêt, l'emplacement desdites soupapes d'arrêt dépendant du poids relatif du gaz inerte de déplacement ;
exposer l'ébauche de plaque d'impression photodurcissable incluant la couche de masque détachée par ablation et les portions exposées de la couche photodurcissable à un flot de rayonnement actinique, le rayonnement actinique passant à travers les ouvertures (14) ménagées dans la couche de masque détachée par ablation afin de durcir les portions exposées de la couche photodurcissable ; et
enlever la couche de masque détachée par ablation et les portions non durcies de la couche photodurcissable afin de créer une image en relief formée par une série de colonnes (28) qui reproduisent l'image.

3. Procédé selon la revendication 2, un vide étant appliqué à la chambre avant ou pendant l'introduction du gaz inerte en provenance du réservoir (68).

4. Procédé selon la revendication 1 ou 2, l'environnement à oxygène réduit contenant de l'oxygène dans une quantité inférieure à 10,5 % par volume.

5. Procédé selon la revendication 1 ou 2, ledit environnement incluant du gaz inerte, du dioxyde de carbone et / ou de l'argon ayant été fourni.

6. Procédé selon l'une quelconque des revendications précédentes, le rayonnement actinique incluant une lumière qui est projetée à travers un polarisateur.

7. Procédé d'impression sur un matériau ondulé en utilisant une forme d'impression en relief formée conformément au procédé selon les revendications 1 à 6.

8. Procédé selon les revendications 1 à 6, dans lequel l'environnement contient de l'oxygène dans une quantité inférieure à 5,3 % par volume.

9. Procédé selon les revendications 1 à 6, dans lequel l'environnement contient de l'oxygène dans une quantité inférieure à 2,1 % par volume.
